# EUROPÄISCHE PATENTSCHRIFT

(11) **EP 0 479 333 B1**
(45) Veröffentlichungstag und Bekanntmachung des Hinweises auf die Patenterteilung: **28.02.1996**
(21) Anmeldenummer: 91119417.3
(22) Anmeldetag: 21.12.1988
(51) Int. Cl.: H03M 1/30, G06K 11/06, H03J 9/06

(54) **Drahtloses Fernsteuersystem elektronischer Geräte**
Wireless remote control system of electronic sets
Télécommande sans fil pour appareils électroniques

(30) Priorität: 30.04.1988 EP 88106983
(43) Veröffentlichungstag der Anmeldung: 08.04.1992
(62) Teilanmeldung aus: 88121384.7
(73) Patentinhaber: Deutsche ITT Industries GmbH, D-79108 Freiburg (DE)
(72) Erfinder: Heberle, Klaus, Dipl.-Ing. (FH), W-7801 Reute (DE)

(56) Entgegenhaltungen:
- EP-A- 0 206 246
- EP-A- 0 209 411
- US-A- 2 948 890

## Beschreibung

Übliche Fernsteuergeber von drahtlosen Fernsteuersystemen elektronischer Geräte, insbesondere solcher der Unterhaltungselektronik, erzeugen in Abhängigkeit von vom Benutzer zu betätigenden Tasten Steuersignale für das bzw. die zu steuernden Geräte. Dabei dient als Übertragungsmedium ein entsprechend moduliertes Ultraschall- bzw. Infrarot-Signal.

Im Hinblick auf die Vielzahl der heute möglichen und damit auch erforderlichen Steuerbefehle erscheint es nicht mehr tragbar, die Anzahl der Tasten des Fernsteuergebers weiter zu erhöhen, sondern sie ist gerade drastisch zu verringern, ohne dabei jedoch die Steuermöglichkeiten zu reduzieren.

Aus EP-A-0 209 411 ist ein Steuersystem für ein elektronisches Gerät bekannt, das einem Piloten mittels einer Kopfbewegung ermöglicht, ein Steuersignal auszulösen. Dabei werden dem Piloten mittels eines Bildschirms eine Vielzahl von Steuerbefehlen zur Auswahl angeboten. Jeder Steuerbefehl ist einem auf dem Bildschirm dargestellten kleinen Feld zugeordnet und der Pilot wählt daraus den gewünschten Steuerbefehl aus. Dieses Verfahren ist bei der Bedienung von Computern unter dem Namen "Menü-Steuerung" bekannt. Statt der üblichen Menü-Auswahl beim Computer mittels einer manuell bewegten "Maus" erfolgt in der Anordnung nach EP-A-0 209 411 die Menü-Auswahl durch die Kopfbewegung des Piloten. Hierzu wird die relative Position zwischen dem Helm des Piloten und einem festen Bezugspunkt mittels eines elektrooptischen Systems bestimmt. Dieses besteht im wesentlichen auf der Fernbedienungsempfängerseite aus einer optischen Strahlungsquelle, die räumlich fest angeordnet ist, und auf der Fernbedienungsgeberseite aus einem optischen Vierquadranten-Strahlungsdetektor, der fest mit dem Pilotenhelm verbunden und auf die Strahlungsquelle ausgerichtet ist. Mit der Kopfbewegung ändert sich die Lage der abgebildeten Strahlungsquelle auf dem mitbewegten Strahlungsdetektor - der Leuchtfleck bewirkt dabei eine andere Lichtverteilung auf dem Vierquadranten-Strahlungsdetektor. Seine elektrischen Ausgangssignale werden über Draht einer teilweise analog, teilweise digital arbeitenden Rechenschaltung zugeführt, die mit der Ablenkeinheit und Strahlsteuerung des Bildschirmes gekoppelt ist und dort dasjenige Feld hervorhebt, das der jeweiligen Helmausrichtung zugeordnet ist.

Aus GB-A 1 203 597 ist ein Gerät bekannt, das eine x-y-Koordinateneinstellung über jeweils eine Linienrasterplatte in x- und y-Richtung steuert, wobei die jeweilige Anzahl der durchlaufenen Linien optisch abgetastet und elektronisch gezählt wird.

Aus EP-A-0 206 246 ist eine optisch gesteuerte "Maus" zur Computersteuerung bekannt, die über diagonal liegende photoempfindliche Sensoren das Gitterraster eines "Tabletts" abtastet und die elektrischen Signale einer Auswertungsschaltung zuführt. Zur Steuerung wird die Maus manuell auf dem Tablett in beliebiger Richtung bewegt.

Aus US-A -3 996 463 ist ein Gerät bekannt, das mittels des Fraunhoferschen Diffraktionseffekts die relative Position zwischen einem Lichtstrahl und einem optischen Gitter auswertet. Dies ermöglicht eine genaue Positionsbestimmung bei sehr kleinen Relativbewegungen.

Aus US-A -2 948 890 ist eine weitere Anordnung bekannt, die an einem Gerät eine relative Positionsbestimmung in einer Richtung mittels elektrooptischer Mittel ermöglicht. Diese Anordnung verwendet eine Maske mit streifenförmigen Öffnungen und einen dahinterliegenden Reflektor mit streifenförmigen Reflexionszonen. Die Relativbewegung zwischen der Streifenmaske und dem dahinterliegenden Reflektor erzeugt ein Hell-Dunkel-Signal, dessen Wechsel zur Positionsbestimmung elektronisch ausgewertet wird. Dies erfolgt beispielsweise durch einfache Zählung der Helligkeitsimpulse. Der jeweilige Richtungssinn der Bewegung wird durch eine parallele zweite Streifenmaske ermittelt, die gegenüber der ersten etwas versetzt ist und entsprechend ein zeitlich versetztes Hell-Dunkel-Signal erzeugt.

In der europäischen Stammanmeldung EP-A-0 340 343 und der weiteren europäischen Teilanmeldung EP-A-0 478 002 - beide mit gleichem Zeitrang wie die vorliegende europäische Teilanmeldung - werden weitere drahtlose Fernsteuersysteme für elektronische Geräte beschrieben, die die Relativbewegung zwischen einem Fernbedienungsgeber und einem Fernbedienungsempfänger mittels elektrooptischer Mittel in elektronische Signale umwandeln, aus denen sich auf einfache Weise die Relativbewegung oder die jeweilige Position ermitteln lassen.

Es ist Aufgabe der in den Ansprüchen gekennzeichneten Erfindung, das in EP-A-0 209 411 beschriebene elektrooptische System an ein drahtloses Fernsteuersystem für elektronische Geräte, insbesondere der Unterhaltungselektronik, anzupassen. Somit können aus der Relativbewegung zwischen Fernsteuergeber und einer ortsfesten Strahlungsquelle, die z.B. am zu steuernden Gerät angebracht ist, Signale abgeleitet werden, die eine Information über die Bewegungsrichtung und die Bewegungsgeschwindigkeit des Fernsteuergebers enthalten.

Mittels dieser Signale und des in heute üblichen Fernsteuergebern bzw. elektronischen Geräten vorhandenen und entsprechend programmierten Mikroprozessors können die Fernsteuersignale erzeugt werden.

Die Erfindung wird nun anhand der Figuren der Zeichnung näher erläutert:
Fig. 1 zeigt stark schematisiert eine Ausführungsform der Erfindung, bei der der Jalousie-Effekt zweier hintereinanderliegender Streifengitter im Fernsteuergeber angewendet wird,
Fig. 2 zeigt die Zuordnung der beiden Teilgitter des zweiten Streifengitters der Ausführungsform nach Fig. 1,
Fig. 3 zeigt eine einfache Schaltung zur Ableitung von Richtungssignalen aus den beiden Ausgangssignalen der Anordnung nach Fig. 1,
Fig. 4 zeigt den typischen Kurvenverlauf der beiden Strahlungsdetektor-Ausgangssignale von Fig. 1 und
Fig. 5a und 5b zeigen Kurvenverläufe der Eingangs- und Ausgangssignale der Fig. 3.

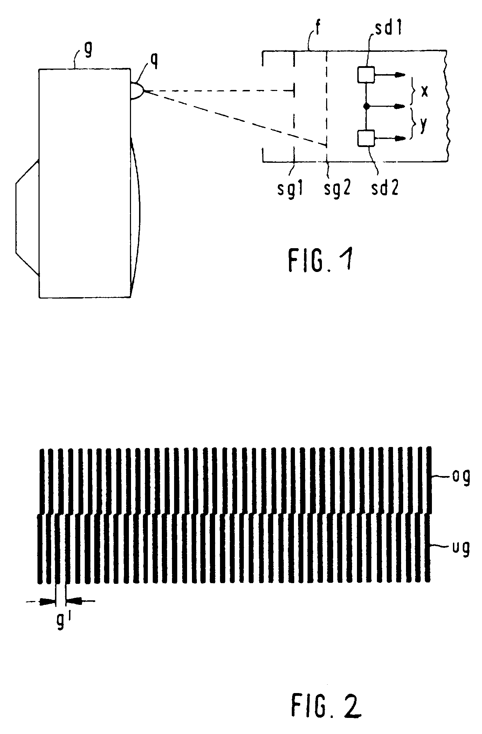

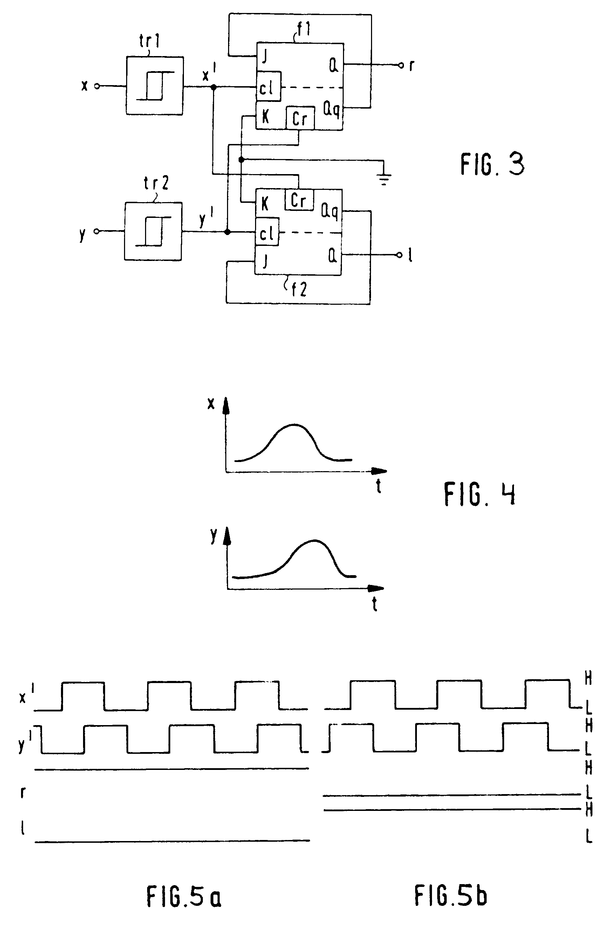

Bei der in Fig. 1 stark schematisiert gezeigten Ausführungsform der Erfindung enthält das elektrooptische System als optischen Eingang das erste optische Streifengitter sg1 und im Strahlengang dahinter und in einigem Abstand parallel dazu das zweite optische Streifengitter sg2 mit gleicher oder kleinerer Gitterkonstante. Dieses besteht, wie in Fig. 2 veranschaulicht ist, aus dem oberen Teilgitter og und dem unteren Teilgitter ug, dessen Streifen um ein Viertel der Gitterkonstanten g' gegenüber den Streifen des oberen Teilgitters og versetzt sind. Hinter dem oberen Teilgitter og ist der Strahlungsdetekor sd1 und hinter dem unteren Teilgitter ug der Strahlungsdetektor sd2 angeordnet, an deren jeweiligem Ausgang die Signale x, y entstehen, vgl. Fig. 4.

Bei diesem Verfahren wird eine Art "Jalousie-Effekt" ausgenutzt, wenn infolge der Bewegung des Fernsteuergebers der Schatten des ersten Streifengitters sg1 über das zweite Streifengitter sg2 läuft. Die so entstehenden optischen Interferenzen werden durch die beiden Strahlungsdetektoren sd1, sd2 in die elektrischen Signale x, y umgewandelt. Der erforderliche Abstand der beiden Streifengitter sg1, sg2 ergibt sich aus dem noch gut aufzulösenden Drehwinkel und der Gitterkonstante des zweiten Streifengitters, ohne daß dabei die manuelle Bewegungssteuerung zu empfindlich oder zu unempfindlich wird. Die Kurvenform der Signale x, y entspricht qualitativ dem in Fig. 4 dargestellten Signalverlauf, das heißt die Maxima sind infolge der Bewegung des Fernsteuergebers zeitlich gegeneinander versetzt.

Die Fig. 3 zeigt eine einfache Schaltung aus den beiden Schmitt-Triggern tr1, tr2 und den beiden JK-Flipflops f1, f2, mit denen aus den Ausgangssignalen x, y der elektrooptischen Eingangsstufe nach Fig. 1 die elektrischen Signale r, l erzeugt werden können, die unter anderem die Information über die Bewegungsrichtung des Fernsteuergebers f enthalten.

Die in der Fig. 5a und 5b dargestellten rechteckförmigen Ausgangssignale x', y' entsprechen somit idealisiert dem zeitlichen Ablauf des über die jeweiligen Strahlungsdetektoren sd1, sd2 hinweggeführten Hell-Dunkelrasters. Im einzelnen ist mit dem jeweiligen Ausgangssignal der Schmitt-Trigger tr1, tr2 der jeweilige Takteingang cl der beiden JK-Flipflops f1, f2 gespeist. Ferner ist der Clear-Eingang Cr des JK-Flipflops f2 mit dem Ausgang des Schmitt-Triggers trl und der Clear-Eingang Cr des JK-Flipflops fl mit dem Ausgang des Schmitt-Triggers tr2 verbunden. Die beiden K-Eingänge der JK-Flipflops f1, f2 liegen am Schaltungsnullpunkt, während in jedem Flipflop der J-Eingang mit dem Qq-Ausgang verbunden ist. Am Q-Ausgang des Flipflops f1 entsteht das Signal r, das eine Rechtsbewegung anzeigt, und am Q-Ausgang des Flipflops f2 das Signal 1, das eine Linksbewegung anzeigt. Die Schmitt-Trigger tr1, tr2 bilden aus den Ausgangssignalen x, y, die eher sin- oder sin-förmig sind, vgl. Fig. 4, die in Fig. 5a und 5b gezeigten Rechtecksignale x', y'.

Die in Fig. 3 gezeigte einfache Auswerteschaltung erzeugt lediglich die Information, ob eine Rechts- oder eine Linksbewegung vorliegt. Zur Auswertung der zugehörigen Geschwindigkeit kann die momentane Frequenz der Rechtecksignale x', y' ausgewertet werden, vgl. Fig. 5a und 5b. Aus der von einem bestimmten Zeitpunkt an akkumulierten Taktanzahl von x' oder y' kann die Bewegungsweite bestimmt werden.

Die Fig. 5a zeigt den zeitlichen Verlauf der Signale x', y', r, 1 bei einer Rechtsbewegung, bei der die x'-Signale gegenüber den y'-Signalen voreilen, während die Fig. 5b den Fall für eine Linksbewegung zeigt, in der die x'-Signale den y'-Signalen nacheilen. In Fig. 5a hat das r-Signal den H-Pegel und das 1-Signal den L-Pegel. In Fig. 5b hat das l-Signal den H-Pegel und das r-Signal den L-Pegel (der H-Pegel ist der positivere der beiden vom jeweiligen Q-Ausgang einnehmbaren Pegel H, L).

Die in Fig. 5a und 5b gezeigten vier Signale enthalten wie angegeben sowohl die Information über die Bewegungsrichtung des Fernsteuergebers f als auch Informationen darüber, wie weit und wie schnell er bewegt wird. Somit ist es für den Fachmann ohne weiteres möglich, den eingangs erwähnten, im Fernsteuergeber oder elektronischen Gerät vorhandenen Mikroprozessor mit diesen Signalen anzusteuern und daraus entsprechende Fernsteuersignale für das elektronische Gerät g zu bilden. Mittels der Information über die Bewegungsweite des Fernsteuergebers f läßt sich ein analoges bzw. kontinuierliches Steuersignal, wie z.B. für die Lautstärke oder für die Helligkeit oder den Kontrast, erzeugen. Es sind jedoch auch sogenannte Menü-Steuerungen möglich, wie sie von Computern und der bekannten sogenannten Maus her bekannt und üblich sind. Der Fernsteuergeber kann somit nach der Erfindung als "elektronische Maus" ausgebildet werden.

Es kann zweckmäßig sein, in den Fernsteuergeber ein zweites elektrooptisches System vom gleichen Aufbau wie das vorhandene elektrooptische System nach den Figuren 1 bis 3 einzubauen, das dann gegenüber dem ersten um 90^{o} gedreht angeordnet ist, dies ermöglicht dann zusätzlich die vertikale Bewegungserkennung.

Wird die Strahlung der Strahlungsquelle q moduliert, so ist auch eine bi-direktionale Datenverbindung mit dem Fernsteuergeber möglich.

## Patentansprüche

1. Drahtloses Fernsteuersystem elektronischer Geräte
- mit einem Fernsteuergeber (f) und einem im elektronischen Gerät (g) angeordneten Fernsteuerempfänger,
- mit einer im elektronischen Gerät (g) angeordneten Strahlungsquelle (q),
- mit mindestens zwei im Fernsteuergeber (f) angeordneten Strahlungsdetektoren (sd1, sd2) sowie
- mit den Strahlungsdetektoren (sd1, sd2) zugeordneten Mitteln zur Erzeugung von elektrischen Signalen (x, y) aus der Relativbewegung zwischen Fernsteuergeber (f) und Fernsteuerempfänger bzw. elektronischem Gerät (g),
gekennzeichnet durch folgende Merkmale:
- die elektrooptische Eingangsstufe des Fernsteuergebers (f) enthält ein elektrooptisches System, das im Strahlungsverlauf hintereinander angeordnet ein erstes optisches Streifengitter (sg1) und in einigem Abstand dahinter und parallel dazu ein zweites optisches Streifengitter (sg2) mit gleicher oder kleinerer Gitterkonstante aufweist,
- das zweite optische Streifengitter (sg2) besteht aus einem oberen Teilgitter (og) und einem unteren Teilgitter (ug) mit um ein Viertel der Gitterkonstanten (g') gegenüber den Streifen des oberen Teilgitters (og) versetzten Streifen und
- jeweils hinter dem oberen Teilgitter bzw. dem unteren Teilgitter ist der erste bzw. zweite Strahlungsdetektor (sd1, sd2) angeordnet.

2. Drahtloses Fernsteuersystem nach Anspruch 1, dadurch gekennzeichnet, daß die elektrooptische Eingangsstufe ein zweites elektrooptisches System vom gleichen Aufbau wie das (erste) elektrooptische System enthält, wobei das zweite System gegenüber dem ersten in einer zu dessen Ebene parallelen Ebene um 90^{o} gedreht angeordnet ist.

3. Drahtloses Fernsteuersystem nach Anspruch 1 oder 2, dadurch gekennzeichnet, daß die elektronischen Geräte Geräte der Unterhaltungselektronik sind.

4. Drahtloses Fernsteuersystem nach einem der Ansprüche 1 bis 3, dadurch gekennzeichnet, daß mittels der Relativbewegung des Fernsteuergebers (f) gegenüber der Strahlungsquelle (q) analoge bzw. kontinuierliche Steuersignale auf den Fernsteuerempfänger übertragen werden.

5. Drahtloses Fernsteuersystem nach einem der Ansprüche 1 bis 3, dadurch gekennzeichnet, daß mittels der Relativbewegung des Fernsteuergebers (f) gegenüber der Strahlungsquelle (q) Menü-Steuersignale übertragen werden.

6. Drahtloses Fernsteuersystem nach einem der Ansprüche 1 bis 5, dadurch gekennzeichnet, daß die Ausgangssignale (x, y) der Strahlungsdetektoren (sd1, sd2) über logische Verknüpfungen Richtungssignale (r, l) erzeugen.

## Claims

1. A wireless remote-control system for electronic apparatus, said remote-control system comprising
- a remote-control transmitter (f) and a remote-control receiver which is contained in the electronic apparatus (g),
- a radiation source (q) contained in the electronic apparatus (g),
- at least two radiation detectors (sd1, sd2) contained in the remote-control transmitter (f), and
- means associated with the radiation detectors (sd1, sd2) for generating electric signals (x, y) from a movement of the remote-control transmitter (f) and the remote-control receiver or the electronic apparatus (g) relative to each other,
characterized by the following features:
- The electrooptical input stage of the remote-control transmitter (f) comprises an electrooptical system which contains in the radiation path a first optical stripe grating (sg1) and, behind the latter at a distance therefrom and parallel thereto, a second optical stripe grating (sg2) having the same or a smaller grating constant;
- the second optical stripe grating (sg2) consists of an upper subgrating (og) and a lower subgrating (ug) with stripes displaced by one-quarter of the grating constant (g') relative to the stripes of the upper subgrating (og); and
- the upper subgrating and the lower subgrating are succeeded by the first radiation detector (sd1) and the second radiation detector (sd2), respectively.

2. A wireless remote-control system as claimed in claim 1, characterized in that the electrooptical input stage comprises a second electrooptical system of the same design as the (first) electrooptical system, with the second system rotated by 90° with respect to the first system in a plane parallel to the plane of the first system.

3. A wireless remote-control system as claimed in claim 1 or 2, characterized in that the electronic apparatus (g) is entertainment-electronics apparatus.

4. A wireless remote-control system as claimed in any one of claims 1 to 3, characterized in that by means of the movement of the remote-control transmitter (f) relative to the radiation source (q), analog or continuous control signals are transmitted to the remote-control receiver.

5. A wireless remote-control system as claimed in any one of claims 1 to 3, characterized in that by means of the movement of the remote-control transmitter (f) relative to the radiation source (q), menu-control signals are transmitted.

6. A wireless remote-control system as claimed in any one of claims 1 to 5, characterized in that the output signals (x, y) from the radiation detectors (sd1, sd2) produce direction signals (r, l) via logic elements.

## Revendications

1. Système de télécommande sans fil d'appareils électroniques, comportant
- un générateur de télécommande (f) et un récepteur de télécommande disposé dans l'appareil électronique (g),
- une source de rayonnement (q) disposée dans l'appareil électronique (g),
- au moins deux détecteurs de rayonnement (sd1, sd2) disposés dans le générateur de télécommande (f), et
- des moyens associés aux détecteurs de rayonnement (sd1, sd2) pour la production de signaux électriques (x, y) à partir du déplacement relatif entre le générateur de télécommande (f) et le récepteur de télécommande ou l'appareil électronique (g),
caractérisé par les caractéristiques suivantes :
- l'étage d'entrée électro-optique du générateur de télécommande (f) contient un système électro-optique, qui comporte un premier réseau optique formé de bandes (sg1) et, à une certaine distance en arrière de et parallèlement à ce réseau, un second réseau optique formé de bandes (sg2) possédant une constante de réseau égale ou inférieure, ces deux réseaux formés de bandes étant disposés l'un derrière l'autre sur le trajet du rayonnement,
- le second réseau optique formé de bandes (sg2) est constitué par un réseau partiel supérieur (og) et un réseau partiel inférieur (ug) comportant des bandes qui sont décalées d'un quart de la constante (g') du réseau par rapport aux bandes du réseau partiel supérieur (og), et
- le premier ou le second détecteur de rayonnement (sd1, sd2) est disposé respectivement en arrière du réseau partiel supérieur ou du réseau partiel inférieur.

2. Système de télécommande sans fil selon la revendication 1, caractérisé en ce que l'étage d'entrée électro-optique contient un second système électro-optique possédant le même agencement que le (premier) système électro-optique, le second système étant disposé en étant pivoté de 90°, par rapport au premier système, dans un plan parallèle au plan de ce système.

3. Système de télécommande sans fil selon la revendication 1 ou 2, caractérisé en ce que les appareils électroniques sont des appareils de l'électronique du spectable.

4. Système de télécommande sans fil selon l'une des revendications 1 à 3, caractérisé en ce que des signaux de commande analogique ou continue sont transmis au récepteur de télécommande au moyen du déplacement relatif du générateur de télécommande (f) par rapport à la source de rayonnement (q).

5. Système de télécommande sans fil selon l'une des revendications 1 à 3, caractérisé en ce que des signaux de commande de menu sont transmis au moyen du déplacement relatif du générateur de télécommande (f) par rapport à la source de rayonnement (q).

6. Système de télécommande sans fil selon l'une des revendications 1 à 5, caractérisé en ce que les signaux de sortie (x, y) des détecteurs de rayonnement (sd1, sd2) produisent des signaux de direction (r,l) par l'intermédiaire de combinaisons logiques.
